# EUROPEAN PATENT APPLICATION

(11) **EP 1 843 577 A1**
(43) Date of publication of application: **10.10.2007**
(21) Application number: 06025057.8
(22) Date of filing: 04.12.2006
(51) Int. Cl.: H04N 5/50, H04N 5/445, H03J 7/18

(54) **Method and system of manually setting programs**

(30) Priority: 04.04.2006 CN 200610074032
(71) Applicant: BenQ Corporation, Gueishan Taoyuan 333 (TW)
(72) Inventor: Chang, Chih-Cheng, Anle District Keelung City 204 (TW)
(74) Representative: Fuchs

(57) **Abstract**

A method of manually setting a program within a frequency range. The method comprises the following steps. A start frequency and a surf direction are set, and then surf programs. When a target program is found or a pause instruction is received, surfing pauses. An auto naming function is executed to obtain a program name of the target program. A user determines whether to keep the program name in a program list. Surfing is repeated until the entire frequency range is searched or a stop instruction is received.

## Description

### BACKGROUND OF THE INVENTION

### Field of the Invention

The invention relates to surfing programs within a frequency range and, more particularly, to setting a certain TV program within a frequency range.

Typical televisions have pre-installed program setting systems for surfing television programs within a frequency range. When a television is first initialized, a user may command a tuner in the television to search television programs. A program list constitutes those television programs that are tuned to when the user presses the program up or the program down buttons on a remote control device. The frequencies of television programs are also recorded in the program list. The next time the television is turned on, the user does not have to re-surf the entire frequency range to know which frequency carries which television program, but simple allows the television to check the program list.

Typical program setting up systems have some drawbacks. When there is no television program in the television frequency range, typical program setting systems do not automatically stop searching. The television would continually stay in a searching status. Some program setting systems always find the same television program and always skip certain programs.

### BRIEF SUMMARY OF THE INVENTION

In one aspect of the invention, a method of manually setting a program within a frequency range is provided. The method comprises the following steps. A start frequency and a surf direction are set, and then surf programs. When a target program is found or a pause instruction is received, surfing pauses. An auto naming function is executed to obtain a program name of the target program. A user determines whether to keep the program name in a program list. Surfing is repeated until the entire frequency range is searched or a stop instruction is received.

In another aspect of the invention, a system for manually setting programs within a frequency range is provided. The frequency range is between a first frequency and a second frequency. The system comprises a tuner, a user interface, a storage unit, and a processing unit. The user interface may receive a pause searching instruction, a store instruction, or a surf direction. The tuner searches the target program according to the surf direction from a starting frequency, and pauses searching when the tuner finds the target program or the user interface receives the pause searching instruction. The target program is a program with a signal comprising program information. The storage unit stores a program list. The processing unit is coupled to the tuner. The processing unit executes an auto naming function to obtain a program name of the target program. When the user interface receives the store instruction, the processing unit keeps the frequency and program name of the target program in the program list.

### BRIEF DESCRIPTION OF THE DRAWINGS

The invention will become more fully understood from the detailed description, given herein below, and the accompanying drawings. The drawings and description are provided for purposes of illustration only, and, thus, are not intended to be limiting of the invention.
- Fig. 1: shows a block diagram of a system for manually setting programs according to an embodiment of the invention; and
- Fig. 2: shows a flowchart of manually setting programs according to an embodiment of the invention.

### DETAILED DESCRIPTION OF THE INVENTION

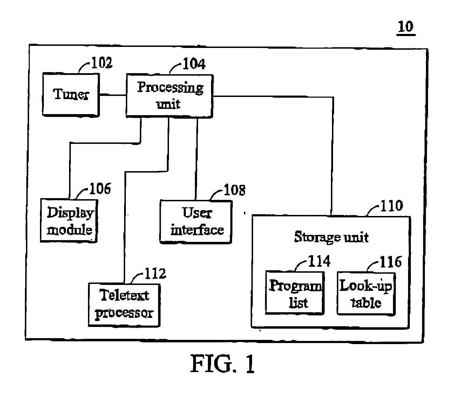

Fig. 1 shows a block diagram of a system for manually setting programs according to an embodiment of the invention. In one embodiment of the invention, the system can be applied to a television or a radio player. The system of manually setting programs comprises a tuner 102, a processing unit 104, a display module 106, a user interface 108, a storage unit 110 and a teletext processor 112. The tuner 102 searches for a target program within a frequency range. In this embodiment of the invention, the frequency range is between a first frequency 41 MHz and a second frequency 866.25MHz. A target program is a program with a signal comprising program information, such as a program code. The storage unit 110 maintains a program list 114. When the processing unit 104 finds a program signal of the target program, the frequency of the target program is kept in the program list 114, The teletext processor 112 can extract a Country Network code, (CNI code) of the target program from the program signal which is searched. The storage unit 110 further stores a look-up table 116 recording the relationship of the CNI codes and the program names. The processing unit 104 retrieves the program name based on the CNI code of the program signal in program list 114. The user interface 108 receives a store instruction, a searching order, or a pause searching instruction. The processing unit 104 can determine the surf direction of the tuner 102 according to aforementioned searching order. The surf direction can be determined by whether the user presses the program up (i.e. program +) or the program down (i.e. program -) buttons or keys on a remote control device. The surfing direction can be from low frequency to high frequency or from high frequency to low frequency. The user interface 108 may be a remote control, and a receiver coupled to the processing unit 104. When a user presses the direction button of the remote control, the receiver can pass the instruction to the processing unit 104.

When processing unit 104 determines that the tuner 102 has found the target program, the tuner 102 stops searching. The processing unit 104 executes an auto naming function to obtain the program name of the target program. Moreover, when the user interface 108 receives the store instruction, the processing unit 104 stores the program name and the frequency of the target program into the program list 114 of the storage unit 110. The display module 106 further displays the program name of the target program.

Table 1 shows an example of the look-up table 116. In this embodiment of the invention, the look-up table has two columns, one column is CNI code, and the other is program name. The CNI code is a unique code, which means different CNI codes indicate different programs, and different programs have different CNI codes.

**Table 1. An example of the look-up table 116**

| CNI code | program name |
|---|---|
| 0x0A0xC1 | HBO |
| 0x0A0xC2 | CNN |
| ... | ... |
| 0x0D0xC1 | BBC |

Table 2 shows an example of the program list. In this embodiment of the invention, the program list has two columns. One column contains CNI codes, and the other contains the frequencies corresponding to the CNI codes. This program list contains the frequencies on which there is program signal within the frequency range for program surfing. The frequency range is between a first program 41 MHz and the second frequency 866.25MHz. In another embodiment of the invention, the column of CNI codes can be replaced by program names.

**Table 2. An example of the program list**

| CNI code | frequency |
|---|---|
| 0x0A0xC1 | 80MHz |
| 0x0A0xC2 | 85MHz |
| ... | ... |
| 0x0D0xC1 | 100MHz |

Another condition for the tuner 102 to stop searching is when the user interface 108 receives a pause searching instruction. Sometimes the program signal is barely watchable, but the program signal is so weak that the program information can not be recognized by the teletext processor 112. The tuner 102 may skip the program signal. A user can send the pause searching instruction to keep the program in the program list 114.

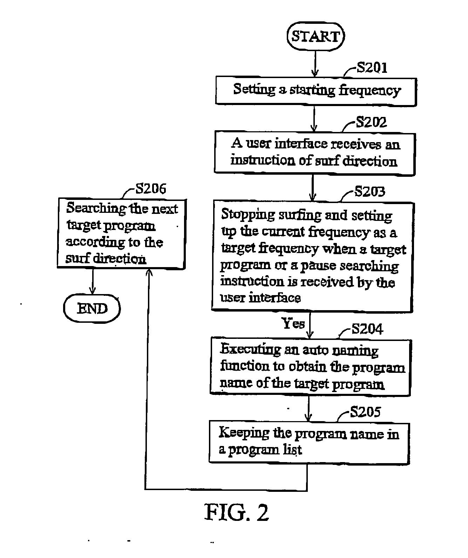

Fig. 2 shows a flowchart of manually setting programs according to an embodiment of the invention. The method is used to surf within a frequency range and find a target program. The frequency range is between a first frequency and a second frequency, and the target program is a program with a signal comprising program information. The program information may be the CNI code of the program. First, a starting frequency is set, in step S201. A surf direction instruction is received by a user interface in step S202. The instruction is for deciding the searching direction. When a target program is searched or a pause searching instruction is received by the user interface, a turner stops surfing and sets up the current frequency as a target frequency in step S203, wherein the target frequency is the frequency of a target program. In step S204, an auto naming function is executed to obtain the program name of the target program by using the CNI code as in index to search a look-up table. The target frequency and the program name are kept in a program list in step S205. Step S206 searches for the next target program according to the surf direction.

For example, suppose the target programs existing in the frequency range are those shown in Tables 1 and 2. When the user interface 108 receives a searching order of "up", the tuner 102 starts with a starting frequency 110MHz toward a second frequency 866.25MHz. The starting frequency in this embodiment is set for easy illustration. In other embodiments of the invention, the starting frequency can be adjusted through user interface 108. Since there are no target frequencies between starting frequency 110MHz and the second frequency 866.26MHz, the tuner 102 then searches the target programs from the first program 41 MHz toward the starting frequency 110MHz. When the tuner 102 searches the frequency near 80MHz, the teletext processor 112 can successfully extract the CNI code 0x0A0xC1 of the target program, and the tuner 102 stops searching. In this embodiment of the invention, the first frequency is defined to be the lower boundary of the frequency range, and the second frequency is defined to be the upper boundary of the frequency range. In other embodiments of the invention, the first frequency can be the upper boundary of the frequency range, and the second frequency can be the lower boundary of the frequency range.

In an embodiment of the invention, the frequency range can be circularly surfed. For example, in a given frequency range from 41 MHz to 866.25MHz, the first frequency can be the upper boundary of the frequency range, i.e., 866.25MHz, and the second frequency can be the lower boundary of the frequency range, which is 41MHz. The tuner searches from the starting frequency toward the 866.25MHz, and when the tuner reaches to the 866.25MHz without finding the target program, the tuner further searches from 41 MHz toward the starting frequency. In short, by the searching method of the embodiment, the frequency range can be fully searched.

In another embodiment of the invention, the frequency range is ''two-stage'' searched. For example, the tuner searches from the starting frequency to the first frequency. If the target program is not found, then the tuner searches from the starting frequency toward the second frequency. The first frequency can be the lower bound of the frequency range, and the second frequency can be the upper bound of the frequency range. In other embodiments of the invention, the first frequency can be the upper bound of the frequency range, and the second frequency can be the lower bound of the frequency range.

A method for manual program setting and a system thereof is provided. The difference between auto setting program and manually setting program lies in, when the auto setting program function is activated, all programs in frequency range will be found, while the manually program setting function only searches upward or downward for another program, and the user can decides whether or not to keep the found program. Suppose a television station is newly built, and television shows are being broadcasted. The user may want to update the information record in the program list. When the user executes an auto setting program function, the tuner will search the entire frequency range, which takes a few minutes. A user, however, can manually execute program setting function around the new program to update the program list, in much less time than auto program setting function requires.

For example, referring Table 1 and Table 2, suppose a user is watching a program with frequency at 80MHz and having a program name of "HBO". When the user wants to set another program, the user sends a search program upward instruction. When the tuner searches to 85MHz, the teletext processor can extract the CNI code 0×0A0×C2 within the program signal. The tuner locks in the program, and stops searching. The program name of the current program, CNN, can be obtained by checking the look-up table (Table 1). The frequency of the current program is recorded in the program list (Table 2). In the embodiment of the invention, the tuner searches for a program signal and then stops searching. In other embodiment of the invention, when the user interface receives a pause searching instruction command by a user, the searching of the tuner pauses as well. When the tuner can not successfully determine if a frequency carries a program signal and thus the tuner skips the frequency, the user may command a pause searching instruction to manually set the program. The program name of a program set manually upon the user's pause searching instruction can also be extracted from the look-up table as described in step S203 and S204.

While the invention has been described by way of example and in terms of preferred embodiment, it is to be understood that the invention is not limited thereto. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A method of manually setting programs within a frequency range, wherein the frequency range is between a first frequency and a second frequency, the method comprising:
(A) providing a starting frequency and a surf direction, and searching for a target program according to the surf direction, wherein the target program is a program with a signal comprising program information;
(B) recording a current frequency as a target frequency when finding the target program or receiving a pause searching instruction;
(C) executing an auto naming function to obtain a program name of the target program;
(D) determining whether to record the program name and the target frequency in a program list; and
(E) continuing to surf according to the surf direction, and returning to step (B).

2. The method as claimed in claim 1, wherein the surf direction in step (A) is surfing from the starting frequency toward to the first frequency, and when reaching to the first frequency, surfing from the second frequency toward the starting frequency.

3. The method as claimed in claim 1 further comprising stopping searching for the target program upon reaching the starting frequency.

4. The method as claimed in claim 1, wherein the surf direction in step (A) is a direction from the starting frequency toward the first frequency, and when reaching to the first frequency, surfing from the starting frequency toward the second frequency.

5. The method as claimed in claim 4 further comprising stopping searching the target program upon reaching the second frequency.

6. The method as claimed in claim 1, wherein the first and second frequencies are adjustable,

7. The method as claimed in claim 1, between step (C) and step (D), further comprising:
(C-1) displaying the program name of the target program,

8. The method as claimed in claim 1, wherein the target program is a television program.

9. The method as claimed in claim 1, wherein the program information comprises a program code and the auto naming function of the step (C) comprises:
obtaining the program code from the program information of the target program; and
retrieving the program name from a table, wherein the table comprises the program code and the program name corresponded to the program code.

10. The method as claimed in claim 1 further comprising stopping searching program when receiving a stopping searching instruction during executing step (A) to step (E).

11. A system for manually setting programs within a frequency range, wherein the frequency range is between a first frequency and a second frequency, and the system comprises:
a user interface receiving a pause searching instruction, a store instruction, and a surf direction;
a tuner searching for a target program according to the surf direction from a starting frequency, and pausing searching when the target program is found at a target frequency or the user interface receives the pause searching instruction, wherein the target program is a program with a signal comprising program information:
a storage unit storing a program list; and
a processing unit coupled to the tuner, the user interface and the storage unit, executing an auto naming function to obtain a program name of the target program, and when the user interface receives the store instruction, storing the target frequency and program name of the target program into the program list.

12. The system as claimed in claim 11 further comprising a display module displaying the program name of the target program obtained by the processing unit.

13. The system as claimed in claim 11, wherein the storage unit further comprises a look-up table, the look-up table comprises a program code and the program name corresponding to the program code, and the system further comprises a teletext processing unit to obtain the program code from the program information; when the auto naming function is executed, the processing unit searches the look-up table in the storage unit by the program code to obtain the program name of the target program.

14. The system as claimed in claim 13, wherein the program code is a Country Network (CNI) code.

15. The system as claimed in claim 11, wherein the surf direction is surfing from the starting frequency toward the first frequency, and upon reaching the first frequency, surfing from the second frequency toward the starting frequency.

16. The system as claimed in claim 15, wherein the tuner stops searching the target program when the tuner searches to the starting frequency.

17. The system as claimed in claim 11, wherein the surf direction is searching from the starting frequency toward the first frequency, and upon reaching the first frequency, searching form the starting frequency toward the second frequency.

18. The system as claimed in claim 17, wherein the tuner stops searching the target program when the tuner searches to the second frequency.

19. The system as claimed in claim 11, wherein the user interface receives a pause searching instruction, and when the user interface receives the pause searching instruction, the tuner stops searching.

20. The system as claimed in claim 11, wherein the first frequency and the second frequency can be adjusted via the user interface.
